# EUROPÄISCHE PATENTSCHRIFT

(11) **EP 0 894 324 B1**
(45) Veröffentlichungstag und Bekanntmachung des Hinweises auf die Patenterteilung: **27.06.2001**
(21) Anmeldenummer: 97921613.2
(22) Anmeldetag: 16.04.1997
(51) Int. Cl.: G11C 16/04, G11C 16/06

(54) **PROGRAMMIERBARER FESTWERTSPEICHER MIT VERBESSERTER ZUGRIFFSZEIT**
PROGRAMMABLE READ-ONLY MEMORY WITH IMPROVED ACCESS TIME
MEMOIRE MORTE PROGRAMMABLE A TEMPS D'ACCES PLUS RAPIDE

(30) Priorität: 18.04.1996 DE 19615407
(43) Veröffentlichungstag der Anmeldung: 03.02.1999
(73) Patentinhaber: Infineon Technologies AG, 81669 München (DE)
(72) Erfinder: SEDLAK, Holger, D-81541 München (DE)
(74) Vertreter: Zedlitz, Peter, Dipl.-Inf.
(86) Internationale Anmeldenummer: DE9700763
(87) Internationale Veröffentlichungsnummer: WO9740501

(56) Entgegenhaltungen:
- EP-A- 0 589 266
- US-A- 4 612 630

## Beschreibung

Die Erfindung betrifft einen programmierbaren Festwertspeicher vom EEPROM-Typ, dessen Speicherzellen mit einem eine isolierte Gateelektrode aufweisenden Speichertransistor und einem dazu in Serie geschalteten Auswahltransistor gebildet sind, wobei der Drainanschluß eines jeweiligen Auswahltransistors mit einer Bitleitung und der Gateanschluß eines jeweiligen Auswahltransistors mit einer Wortleitung verbunden ist und der Steuergateanschluß der Speichertransistoren mit einer Lesespannung beaufschlagbar ist.

Ein solcher programmierter Festwertspeicher ist aus der US -A 4,612,630 bekannt. Dort ist desweiteren vorgeschlagen, die Lesespannung zu ändern, um die in einem jeweiligen Programmierzustand sich einstellende Schwellwertspannung zu ermitteln.

Die EP-A-0 589 266 beschreibt einen Mikrocomputer mit einem EEPROM-Speicher, bei dem die von außen zuführbare Taktfrequenz auf einen Grenzwert, bei dem ein Lesen des EEPROM-Speichers sicher gewährleistet ist, begrenzt wird.

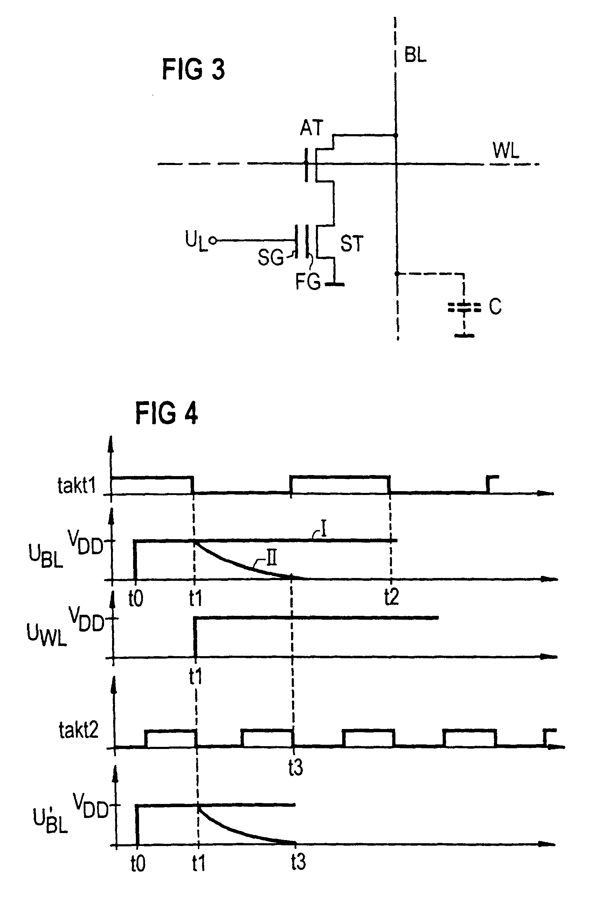

Bei solchen programmierbaren Festwertspeichern vom EEPROM-Typ ist also eine Speicherzelle mit zwei MOS-Transistoren aufgebaut und am Kreuzungspunkt einer Wortleitung WL mit einer Bitleitung BL angeordnet. Dies ist in Figur 3 dargestellt. Einer der Transistoren ST weist eine isolierte Gateelektrode FG auf, mit deren Ladungszustand die Einsatzspannung dieses Transistors eingestellt werden kann. Dieser Transistor ST ist der eigentliche Speichertransistor. Bei einer gelöschten Speicherzelle mit n-Kanal-Transistoren ist die isolierte Gateelektrode negativ geladen, so daß die Einsatzspannung des Speichertransistors ST zu höheren Werten hin verschoben ist. Bei einer programmierten Speicherzelle ist die isolierte Gateelektrode entladen oder sogar positiv geladen. Die Einsatzspannung entspricht dann der eines üblichen MOS-Transistors oder ist niedriger. An die Steuergateelektrode SG des Speichertransistors ST wird zum Lesen eine Lesespannung U_{L} angelegt, die etwa zwischen den Einsatzspannungen eines programmierten und eines gelöschten Speichertransistors liegt. Ist der Transistor gelöscht, sperrt er, ist er programmiert, wird er leiten. Bei p-Kanal-Transistoren sind die Verhältnisse genau umgekehrt.

In Serie zu diesem Speichertransistor ST ist ein Auswahltransistor AT geschaltet, dessen Drainelektrode mit einer Bitleitung BL und dessen Gateelektrode mit einer Wortleitung WL verbunden ist. Durch Anlegen einer Spannung, die etwa der Versorgungsspannung V_{DD} entspricht, an die Wortleitung WL bzw. das Gate des Auswahltransistors AT wird dieser leitend und schaltet den Drainanschluß des Speichertransistors ST an die Bitleitung BL. Diese wird vor einem Lesevorgang auf etwa das Versorgungsspannungspotential V_{DD} geladen. Wenn die Zelle gelöscht ist, sperrt der Speichertransistor ST und die Bitleitung BL bleibt auf dem Versorgungsspannungspotential V_{DD}. Es wird eine logische "1" ausgelesen. Wenn die Zelle programmiert ist, leitet der Speichertransistor ST und die Bitleitung BL entlädt sich über ihn, so daß nach einer gewissen Zeit eine logische "0" detektiert werden kann. Dieser Sachverhalt ist im oberen Teil der Figur 4 dargestellt. Zu einem Zeitpunkt t0 wird die Bitleitüng BL auf eine Spannung U_{BL} mit einem Wert von etwa V_{DD} aufgeladen. Mit beispielsweise der fallenden Flanke eines Taktsignals takt1 wird zum Zeitpunkt t1 die Spannung U_{WL} an der Wortleitung WL auf einen Wert von etwa V_{DD} geschaltet. Im Fall einer gelöschten Zelle, die mit einer I dargestellt ist, bleibt die Spannung U_{BL} der Bitleitung auf dem Wert V_{DD}, während im Fall einer programmierten Zelle, die mit einer II dargestellt ist, die Spannung U_{BL} der Bitleitung abnimmt.

Wenn die Frequenz des Taktsignals takt1 genügend klein ist, kann mit der nächsten fallenden Flanke zum Zeitpunkt t2 ein Auswertevorgang getriggert werden. Zu diesem Zeitpunkt hat sich die Bitleitung BL bereits ausreichend entladen, um eindeutig einen programmierten Zustand detektieren zu können.

Soll jedoch die Zugriffszeit verkleinert werden, muß die Taktfrequenz erhöht werden. In Figur 4 ist als Beispiel eine doppelt so hohe Taktfrequenz takt2 dargestellt. Dort würde nach einem Aufschalten der Versorgungsspannung V_{DD} auf die Wortleitung WL zum Zeitpunkt t1 nach einer Periode zum Zeitpunkt t3 eine Auswertung stattfinden. Zu diesem Zeitpunkt hat sich die Bitleitung BL im Falle einer programmierten Zelle aber noch nicht völlig entladen, so daß die Gefahr einer Fehldetektion besteht.

Die Aufgabe der vorliegenden Erfindung ist es somit, einen programmierbaren Festwertspeicher vom EEPROM- oder Flasch-Typ anzugeben, bei dem bei beliebieger Zugriffszeit ein eindeutiges Lesen möglich ist.

Die Aufgabe wird durch einen Festwertspeicher gemäß dem Anspruch 1 gelöst. Vorteilhafte Weiterbildungen sind in den Unteransprüchen angegeben.

Der erfindungsgemäße programmierbare Festwertspeicher erlaubt eine anwendungsabhängige Wahl der Frequenz des Taktsignals ohne auf schaltungsbedingte Einschränkungen bezüglich der Lese-Zugriffszeiten auf den Speicher Rücksicht nehmen zu müssen.

Die Erfindung wird nachfolgend anhand eines Ausführungsbeispieles mit Hilfe von Figuren näher erläutert. Dabei zeigen
- Figur 1: eine EEPROM-Speicherzelle mit einer erfindungsgemäßen Beschaltung,
- Figur 2: einen möglichen Verlauf der U_{L}'-f_{Cl}-Kennlinie,
- Figur 3: eine EEPROM-Speicherzelle gemäß dem Stand der Technik und
- Figur 4: den zeitlichen Verlauf einiger Spannungen beim Lesen einer Zelle.

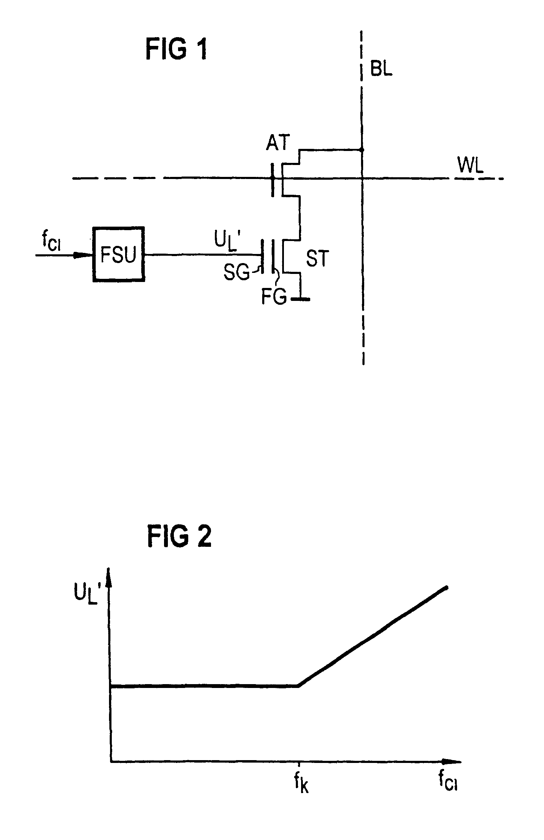

In Figur 1 ist zur Verdeutlichung der Erfindung nur eine Speicherzelle eines programmierbaren Speichers vom EEPROM-Typ dargestellt. Der gesamte Speicher ist mit einer Vielzahl solcher Speicherzellen, die matrixförmig entlang einem Gitter von Wortleitungen WL und Bitleitungen BL angeordnet sind und mittels dem Fachmann geläufiger, nicht dargestellter Schaltungen adressiert werden können, gebildet.

Die Erfindung läßt sich in gleicher Weise auf Flash-Speicher anwenden.

Zum Lesen des Inhalts der Speicherzellen wird die jeweils adressierte Bitleitung BL auf das Versorgungsspannungspotential V_{DD} aufgeladen und dann auf die entsprechende Wortleitung WL ebenfalls das Versorgungsspannungspotential V_{DD} aufgeschaltet, wodurch der Auswahltransistor AT der adressierten Speicherzelle leitend wird. Am Steuergateanschluß SG der Speichertransistoren ST liegt bei allen Speicherzellen des EEPROMs immer eine Lesespannung U_{L}'. Diese Lesespannung U_{L}' ist in erfindungsgemäßer Weise von der Frequenz f_{Cl} des Taktsignals, mit dem die Abläufe beim Lesen aus dem Speicher getriggert werden, abhängig.

Figur 2 zeigt einen möglichen Verlauf der Lesespannung U_{L}' als Funktion der Taktsignalfrequenz f_{Cl}. Bis zu einer bestimmten kritischen Frequenz fₖ bleibt die Lesespannung U_{L}' konstant, dann steigt sie linear an. Es sind aber auch andere Verläufe denkbar, wesentlich ist, daß die Steigung der Kurve größer oder gleich 0 ist.

Der Verlauf der Lesespannung U_{L}' ist abhängig von den Übertragungseigenschaften eines Frequenz-Spannungs-Umsetzers FSU, an dessen Ausgang die Lesespannung U_{L}' bereitgestellt wird. Mit dem Ausgangssignal dieses Frequenz-Spannungs-Umsetzers FSU werden die Steuergate-Anschlüsse SG der Speichertransistoren ST eines erfindungsgemäßen EEPROMs beaufschlagt.

Durch die Erhöhung der Lesespannung U_{L}' wird der Speichertransistor ST leitfähiger, so daß sich die adressierte Bitleitung BL schneller entladen kann. Dies ist im unteren Teil der Figur 4 dargestellt. Mit II ist der Verlauf der Spannung U_{BL}' auf der adressierten Bitleitung BL bei einer programmierten Speicherzelle dargestellt. Hier ist auch bei einer höheren Frequenz des Taktsignals takt2 eine eindeutige Detektion des programmierten Zustandes möglich.

Es ist möglich, daß die adressierte Bitleitung BL auch bei einer gelöschten Zelle aufgrund der höheren Leitfähigkeit des Speichertransistors ST etwas entladen wird, was im unteren Teil der Figur 4 durch einen mit I gekennzeichneten Verlauf der Spannung U_{BL}' auf der Bitleitung BL angedeutet ist. Diese Entladung wird aber immer so gering sein, daß daraus keine Nachteile resultieren.

## Patentansprüche

1. Programmierbarer Festwertspeicher vom EEPROM-Typ, dessen Speicherzellen mit einem eine isolierte Gateelektrode (FG) aufweisenden Speichertransistor (ST) und einem dazu in Serie geschalteten Auswahltransistor (AT) gebildet sind, wobei der Drainanschluß eines jeweiligen Auswahltransistors (AT) mit einer Bitleitung (BL) und der Gateanschluß eines jeweiligen Auswahltransistors (AT) mit einer Wortleitung (WL) verbunden ist und der Steuergateanschluß (SG) der Speichertransistoren (ST) mit einer Lesespannung (U_{L}') beaufschlagbar ist,
**dadurch gekennzeichnet**,
daß Mittel (FSU) vorgesehen sind, die den Wert der Lesespannung (U_{L}') von der Frequenz (f_{Cl}) des Lesetaktes (takt1; takt2) abhängig machen derart, daß die Leitfähigkeit des Speichertransistors (ST) bei relativ hoher Frequenz des Lesetaktes höher ist als bei relativ niedriger Frequenz des Lesetaktes.

2. Festwertspeicher nach Anspruch 1,
**dadurch gekennzeichnet,**
daß die Speichertransistoren n-Kanal Transistoren sind und daß die Lesespannung (U_{L}') zumindest ab einer bestimmten, kritischen Lesetakt-Frequenz (fₖ) zunimmt.

3. Festwertspeicher nach Anspruch 2,
**dadurch gekennzeichnet,**
daß die Zunahme der Lesespannung (U_{L}') linear verläuft.

4. Festwertspeicher nach einem der vorhergehenden Ansprüche,
**dadurch gekennzeichnet,**
daß der Gateanschluß (SG) des Speichertransistors (ST) vom Ausgangssignal (U_{L}')eines mit dem Lesetakt (takt1; takt2) beaufschlagten Frequenz-Spannungs-Umsetzers (FSU) angesteuert ist.

## Claims

1. Programmable read-only memory of the EEPROM type, whose memory cells are formed by a memory transistor (ST), which has an insulated gate electrode (FG), and a selection transistor (AT), which is connected in series with the said memory transistor, the drain terminal of a respective selection transistor (AT) being connected to a bit line (BL) and the gate terminal of a respective selection transistor (AT) being connected to a word line (WL), and it being possible to apply a read voltage (U_{L}') to the control gate terminal (SG) of the memory transistors (ST), characterized in that means (FSU) are provided, which make the value of the read voltage (U_{L}' ) dependent on the frequency (f_{Cl}) of the reading clock signal (clock1; clock2) in such a way that the conductivity of the memory transistor (ST) is higher at a relatively high frequency of the reading clock signal than at a relatively low frequency of the reading clock signal.

2. Read-only memory according to Claim 1, characterized in that the memory transistors are n-channel transistors, and in that the read voltage (U_{L}') increases at least from a specific, critical reading clock signal frequency (fₖ).

3. Read-only memory according to Claim 2, characterized in that the increase in the read voltage (U_{L}') proceeds linearly.

4. Read-only memory according to one of the preceding claims, characterized in that the gate terminal (SG) of the memory transistor (ST) is driven by the output signal (U_{L}') of a frequency-to-voltage converter (FSU) to which the reading clock signal (clock1; clock2) is applied.

## Revendications

1. Mémoire morte programmable du type EEPROM, dont les cellules de mémoire sont formées d'un transistor de mémoire (ST) comportant une électrode de grille isolée (FG) et d'un transistor de sélection (AT) branché en série avec le précédent, la borne de drain d'un transistor de sélection (AT) respectif étant reliée à une ligne de bit (BL) et la borne de grille d'un transistor de sélection (AT) respectif étant reliée à une ligne de mot (WL) et la borne de grille de commande (SG) des transistors de mémoire (ST) pouvant recevoir une tension de lecture (U_{L}'),
caractérisée par le fait qu'il est prévu des moyens (FSU) qui rendent la valeur de la tension de lecture (U_{L}') dépendante de la fréquence (f_{Cl}) de l'horloge de lecture (takt1 ; takt2) de telle sorte que la conductibilité du transistor de mémoire (ST) est plus grande pour une fréquence relativement grande de l'horloge de lecture que pour une fréquence relativement petite de l'horloge de lecture.

2. Mémoire morte selon la revendication 1,
caractérisée par le fait que les transistors de mémoire sont des transistors à-canal n et que la tension de lecture (U_{L}') s'élève au moins à partir d'une certaine fréquence d'horloge de lecture critique (fₖ).

3. Mémoire morte selon la revendication 2,
caractérisée par le fait que l'élévation de la tension de lecture (U_{L}') est linéaire.

4. Mémoire morte selon l'une des revendications précédentes,
caractérisée par le fait que la borne de grille (SG) du transistor de mémoire (ST) est commandée par le signal de sortie (U_{L}') d'un convertisseur fréquence-tension (FSU) recevant l'horloge de lecture (taktl ; takt2).
